# EUROPEAN PATENT SPECIFICATION

(11) **EP 3 056 584 B1**
(45) Date of publication and mention of the grant of the patent: **04.04.2018**
(21) Application number: 16154794.8
(22) Date of filing: 09.02.2016
(51) Int. Cl.: C23C 14/02, C23C 14/16, C23C 14/32, H01F 41/02, H01F 1/057

(54) **METHOD FOR MAKING ND-FE-B PERMANENT MAGNETS WITH ANTI-CORROSIVE COMPOSITE COATING**
VERFAHREN ZUR HERSTELLUNG VON ND-FE-B-PERMANENTMAGNETEN MIT EINER ANTIKORROSIONSVERBUNDBESCHICHTUNG
PROCÉDÉ DE FABRICATION D'AIMANTS PERMANENTS À BASE DE ND-FE-B À REVÊTEMENT COMPOSITE DE PROTECTION CONTRE LA CORROSION

(30) Priority: 12.02.2015 CN 201510078214
(43) Date of publication of application: 17.08.2016
(73) Proprietor: Yantai Shougang Magnetic Materials Inc., 265500 Yantai (CN)
(72) Inventor: Jia, Daoning, Yantai City 265500 (CN); Peng, Zhongjie, Yantai City 265500 (CN); Yang, Kunkun, Yantai City 265500 (CN)
(74) Representative: Gulde & Partner

(56) References cited:
- CN-A- 102 041 506
- STARSICH F H L ET AL: "Gas-phase synthesis of magnetic metal/polymer nanocomposites", NANOTECHNOLOGY, vol. 25, no. 50, 19 December 2014 (2014-12-19), pages 1-7, XP002758439, INSTITUTE OF PHYSICS PUBLISHING GBR DOI: 10.1088/0957-4484/25/50/505602

## Description

The present invention deals about a surface treatment technology of Nd-Fe-B permanent magnets. More specifically, the invention relates to Nd-Fe-B permanent magnets having an anti-corrosive coating and a corresponding manufacturing method.

### Technical Background

Nd-Fe-B permanent magnets in damp environment easily rust because of containing a large amount of rare earth metals. In order to prevent rusting, it is generally known to dispose an anti-corrosion layer on the Nd-Fe-B permanent magnets surface by electroplating.

However, conventional anti-corrosion coating does not satisfy the extraordinary conditions for use of Nd-Fe-B permanent magnets in wind power generators. For example, conventional aluminum coating or epoxy resin coating do not fulfil specific test requirements for wind power generators.

CN 102 041 506 A discloses an Nd-Fe-B permanent magnet with an Al layer and an epoxy resin layer disposed thereon.

### Summary of Invention

The invention overcomes the shortage of the existing technologies.

According to the present invention there is provided a method for disposing an anti-corrosion coating on Nd-Fe-B permanent magnets. The method includes the steps of:
a) Performing a pre-treatment of the Nd-Fe-B permanent magnets;
b) Fixing the Nd-Fe-B permanent magnets on a jig and placing the same in a multi-arc sputtering equipment;
c) Evacuating the multi-arc sputtering equipment with a vacuum system until the pressure reaches 1×10⁻²Pa to 3×10⁻²Pa, then introducing argon gas until the pressure reaches 1×10⁻¹Pa to 5×10⁻¹Pa, starting bias voltage treatment of the Nd-Fe-B permanent magnets for 1 to 10 minutes at 800V to 1000V;
d) Stopping bias voltage treatment and then evacuating the multi-arc sputtering equipment until the pressure reaches 1×10⁻³Pa to 8×10⁻³Pa, then refilling argon gas until the pressure reaches 3×10⁻¹Pa to 5×10⁻¹Pa, then starting arc deposition from a target source and maintain a DC current between 50A to 70A, turn on bias voltage and maintain voltage between 100V to 200V, and maintain coating the magnets for 0.1 to 2h;
e) Cooling down on 20°C to 100°C and taking out the Nd-Fe-B permanent magnets from the multi-arc sputtering equipment;
f) Spray coating of the Nd-Fe-B permanent magnets with an epoxy resin; and
g) Placing the Nd-Fe-B permanent magnets into an oven and heat-treating the same at a treatment temperature between 100°C to 220°C for 10min to 120min.

The technology of multi-arc ion coating has gained rapid development in the recent years, a variety of equipment have been developed and put into use. Multi-arc ion plating technology is an improved method of ion plating and it is a kind of surface coating technology that uses electric arc as the power of vaporizing (said equipment for multi-arc ion plating is referred to as 'multi-arc sputtering equipment').

The Nd-Fe-B permanent magnets used for the present coating process may be preferably sintered Nd-Fe-B permanent magnets or heavy rare earth element diffusion Nd-Fe-B permanent magnets. The heavy rare earth elements may preferably contain Tb or Dy.

Preferably, step a) of pre-treatment of the Nd-Fe-B permanent magnets includes degreasing the surfaces of the magnets with a degreasing fluid, then washing the surfaces with nitric acid having a concentration of 3% to 5%, washing the surfaces with deionized water, optionally applying a soot detergent, and finally blowing-drying of the magnets. Prior to step b), the pre-treated Nd-Fe-B permanent magnets may be again dried in a drying oven.

In step b), water having a temperature of 0°C to 5°C may be used for cooling the multi-arc target in order to prevent big droplet spatter. The Nd-Fe-B permanent magnets placed on the jig may revolve on the jig axis as well as the jig may revolve on axis of the multi-arc sputtering equipment.

The target source of the multi-arc sputtering equipment may be an aluminum target source.

Step f) may include flatting (or arrange) the Nd-Fe-B permanent magnets horizontally.

After step g), the magnets may be cooled down to room temperature and a thickness of the epoxy resin coating may be measured for ensuring a coating thickness between 5µm to 40µm on all relevant surfaces of the magnets.

Preferably, a N50 grade permanent magnet is placed at the back of the target to control arc rotation within the multi-arc sputtering equipment and adjust a distance between the N50 permanent magnet and the aluminum target to be 1cm to 10cm. Hence, the N50 permanent magnet allows controlling the arc rotation and may thus increase the coating efficiency and accelerate the velocity of the arc.

According to another preferred embodiment, the argon gas used in step c) has a purity of more than 99.7%.

According to another preferred embodiment, the aluminum coating has a thickness of 0.5 to 15µm.

According to another preferred embodiment, step g) of heating the epoxy resin coating may be performed at 170°C for 30min. According to another alternative, the magnets are first heated at 120°C for 30min and then heated at 170°C for 30min.

It has been found by the inventors that the corrosion resistance of the magnets is improved significantly compared with conventional methods. The inventive anti-corrosion coating includes an aluminum layer as well as an epoxy layer, which improves the corrosion resistance compared to single coating of aluminum or epoxy resin.

Further embodiments of the invention could be learned for the depending claims and following description.

### Mode of Carrying out the Invention

The present invention will now be described in exemplary embodiments.

### Example 1 - General Description of the Manufacturing Process

a) Degreasing surfaces of the Nd-Fe-B permanent magnets by degreasing fluid, then washing by nitric acid of concentration 4%, deionized water, soot detergent; and finally blowing-dry the Nd-Fe-B permanent magnets.
b) Drying again the Nd-Fe-B permanent magnets at 55°C for 30min in a drying oven, then fixing the Nd-Fe-B permanent magnets on a jig, placing that in a multi-arc sputtering equipment, running the equipment, access 3°C water to cool the multi-arc target, the Nd-Fe-B permanent magnets will be rotating and revolving in the multi-arc sputtering equipment. Employ N50 permanent magnet to control arc rotating within the multi-arc sputtering equipment and adjust the distance between the N50 permanent magnet and aluminum targets to be 5 cm to accelerate the velocity of arc.
c) Pumping via a vacuuming system until the multi-arc sputtering equipment vacuum reaches 2×10⁻²Pa, then filling argon gas with mass percentage of 99.8% until the vacuum reaches 2×10⁻¹⁰Pa, start bias voltage to clean Nd-Fe-B permanent magnets for 5 minutes at 900V.
d) Switching off bias voltage and turn off argon gas filling until the multi-arc sputtering equipment vacuum reaches 6×10⁻³Pa by vacuuming system, refilling the argon gas until the vacuum is 4×10⁻¹Pa, then switching on the power for the target source and maintaining the DC current at 60A, turn on bias voltage and maintaining the same at 150V, coating the magnets for 1.5h until the aluminum film thickness is 10µm.
e) After coating, opening the door of the multi-arc sputtering equipment, when cooled down to 80°C, take out the Nd-Fe-B permanent magnets from the multi-arc sputtering equipment.
f) Place the Nd-Fe-B permanent magnets horizontally, and perform spray coating with epoxy resin.
g) The epoxy resin coated Nd-Fe-B permanent magnets are put into an oven under a curing temperature of 170°C for 50min.
h) After curing, the magnets are cooled down to room temperature, followed by measuring a thickness of the epoxy resin coating to ensure that the epoxy coating thickness is at least 30µm.

### Example 2 - Specific Example

a) Degreasing surfaces of the Nd-Fe-B permanent magnets by degreasing fluid, then washing by nitric acid of concentration 3%, deionized water, soot detergent; and finally blowing-dry the Nd-Fe-B permanent magnets.
b) Drying again the Nd-Fe-B permanent magnets at 50°C for 30min in a drying oven, then fixing the Nd-Fe-B permanent magnets on a jig, placing that in a multi-arc sputtering equipment, running the equipment, access 0°C water to cool the multi-arc target, the Nd-Fe-B permanent magnets will be rotating and revolving in the multi-arc sputtering equipment. Employ N50 permanent magnet to control arc rotating within the multi-arc sputtering equipment and adjust the distance between the N50 permanent magnet and aluminum targets to be 1 cm to accelerate the velocity of arc.
c) Pumping via a vacuuming system until the multi-arc sputtering equipment vacuum reaches 1×10⁻²Pa, then filling argon gas with mass percentage of 99.7% until the vacuum reaches 1×10⁻¹Pa, start bias voltage to clean Nd-Fe-B permanent magnets for 1 minute at 800V.
d) Switching off bias voltage and turn off argon gas filling until the multi-arc sputtering equipment vacuum reaches 1×10⁻³Pa by vacuuming system, refilling the argon gas until the vacuum is 3×10⁻¹Pa, then switching on the power for the target source and maintaining the DC current at 50A, turn on bias voltage and maintaining the same at 100V, coating the magnets for 0.1h until the aluminum film thickness is 0.5µm.
e) After coating, opening the door of the multi-arc sputtering equipment, when cooled down to 20°C, take out the Nd-Fe-B permanent magnets from the multi-arc sputtering equipment.
f) Place the Nd-Fe-B permanent magnets horizontally, and perform spray coating with epoxy resin.
g) The epoxy resin coated Nd-Fe-B permanent magnets are put into an oven under a curing temperature of 100°C for 120min.
h) After curing, the magnets are cooled down to room temperature, followed by measuring a thickness of the epoxy resin coating to ensure that the epoxy coating thickness is at least 40µm.

### Example 3 - Specific Example

a) Degreasing surfaces of the Nd-Fe-B permanent magnets by degreasing fluid, then washing by nitric acid of concentration 5%, deionized water, soot detergent; and finally blowing-dry the Nd-Fe-B permanent magnets.
b) Drying again the Nd-Fe-B permanent magnets at 60°C for 30min in a drying oven, then fixing the Nd-Fe-B permanent magnets on a jig, placing that in a multi-arc sputtering equipment, running the equipment, access 5°C water to cool the multi-arc target, the Nd-Fe-B permanent magnets will be rotating and revolving in the multi-arc sputtering equipment. Employ N50 permanent magnet to control arc rotating within the multi-arc sputtering equipment and adjust the distance between the N50 permanent magnet and aluminum targets to be 10 cm to accelerate the velocity of arc.
c) Pumping via a vacuuming system until the multi-arc sputtering equipment vacuum reaches 1×10⁻²Pa, then filling argon gas with mass percentage of 99.9% until the vacuum reaches 1×10⁻¹Pa, start bias voltage to clean Nd-Fe-B permanent magnets for 1 minute at 800V.
d) Switching off bias voltage and turn off argon gas filling until the multi-arc sputtering equipment vacuum reaches 3×10⁻³Pa by vacuuming system, refilling the argon gas until the vacuum is 5×10⁻¹Pa, then switching on the power for the target source and maintaining the DC current at 70A, turn on bias voltage and maintaining the same at 200V, coating the magnets for 2h until the aluminum film thickness is 15µm.
e) After coating, opening the door of the multi-arc sputtering equipment, when cooled down to 100°C, take out the Nd-Fe-B permanent magnets from the multi-arc sputtering equipment.
f) Place the Nd-Fe-B permanent magnets horizontally, and perform spray coating with epoxy resin.
g) The epoxy resin coated Nd-Fe-B permanent magnets are put into an oven under a curing temperature of 120°C for 30min followed by 170°C for 30 min.
h) After curing, the magnets are cooled down to room temperature, followed by measuring a thickness of the epoxy resin coating to ensure that the epoxy coating thickness is at least 5µm.

Comparative samples with similar thickness of the anti-corrosive coatings have been prepared under the same coating conditions. Comparative Example 1 solely bears a multi-arc sputtering coating (aluminum layer). Comparative Example 2 solely bears an epoxy resin coating.

Salt spray test (SST) were made according to ISO 9227-9227 standard.

Pressure cooker test (PCT) condition: 2 atmosphere, 100%RH, 120°C.

| | thickness | appearance | PCT | SST |
|---|---|---|---|---|
| Example 1 | 40µm | smooth | 240H | 2000H |
| Comparative Example 1 (aluminum layer) | 40µm | rough | 200H | 960H |
| Comparative Example 2 (epoxy resin layer) | 40µm | smooth | 96H | 480H |

As can be clearly seen from the above table, Example 1 coating is better than multi-arc sputtering coating and spray epoxy resin coating under the same coating thickness conditions.

Comparative samples with similar thickness of the anti-corrosive coatings of Example 2 have also been prepared under the same coating conditions. Comparative Example 3 solely bears a multi-arc sputtering coating (aluminum layer). Comparative Example 4 solely bears an epoxy resin coating.

| | thickness | appearance | PCT | SST |
|---|---|---|---|---|
| Example 2 | 40.5µm | smooth | 240H | 2010H |
| Comparative Example 3 (aluminum layer) | 40.5µm | rough | 200H | 967H |
| Comparative Example 4 (epoxy resin layer) | 40.5µm | smooth | 96H | 500H |

As can be clearly seen from the above table, Example 2 coating is better than multi-arc sputtering coating and spray epoxy resin coating under the same coating thickness conditions.

Further, comparative samples with similar thickness of the anti-corrosive coatings of Example 3 have also been prepared under the same coating conditions. Comparative Example 5 solely bears a multi-arc sputtering coating (aluminum layer). Comparative Example 6 solely bears an epoxy resin coating.

| | thickness | appearance | PCT | SST |
|---|---|---|---|---|
| Example 3 | 20µm | smooth | 160H | 960H |
| Comparative Example 5 (aluminum layer) | 20µm | rough | 72H | 360H |
| Comparative Example 6 (epoxy resin layer) | 20µm | smooth | 72H | 240H |

As can be clearly seen from the above table, Example 3 coating is better than multi-arc sputtering coating and spray epoxy resin coating under the same coating thickness conditions.

## Claims

1. A method for disposing an anti-corrosion coating on Nd-Fe-B permanent magnets, the method including the steps of:
a) Performing a pre-treatment of the Nd-Fe-B permanent magnets;
b) Fixing the Nd-Fe-B permanent magnets on a jig and placing the same in a multi-arc sputtering equipment;
c) Evacuating the multi-arc sputtering equipment with a vacuum system until the pressure reaches 1×10⁻²Pa to 3×10⁻²Pa, then introducing argon gas until the pressure reaches 1×10⁻¹Pa to 5×10⁻¹Pa, starting bias voltage treatment of the Nd-Fe-B permanent magnets for 1 to 10 minutes at 800V to 1000V;
d) Stopping bias voltage treatment and then evacuating the multi-arc sputtering equipment until the pressure reaches 1×10⁻³Pa to 8×10⁻³Pa, then refilling argon gas until the pressure reaches 3×10⁻¹Pa to 5×10⁻¹Pa, then starting arc deposition from a target source and maintain a DC current between 50A to 70A, turn on bias voltage and maintain voltage between 100V to 200V, and maintain coating the magnets for 0.1 to 2h;
e) Cooling down on 20°C to 100°C and taking out the Nd-Fe-B permanent magnets from the multi-arc sputtering equipment;
f) Spray coating of the Nd-Fe-B permanent magnets with an epoxy resin; and
g) Placing the Nd-Fe-B permanent magnets into an oven and heat-treating the same at a treatment temperature between 100°C to 220°C for 10min to 120min.

2. The method of claim 1, wherein the Nd-Fe-B permanent magnets are sintered Nd-Fe-B permanent magnets or heavy rare earth element diffusion Nd-Fe-B permanent magnets.

3. The method of claim 1, wherein step a) of pre-treatment of the Nd-Fe-B permanent magnets includes degreasing the surfaces of the magnets with a degreasing fluid, then washing the surfaces with nitric acid having a concentration of 3% to 5%, washing the surfaces with deionized water, and finally blowing-drying of the magnets.

4. The method of claim 1, wherein in step b) water having a temperature of 0°C to 5°C is used for cooling the multi-arc target.

5. The method of claim 1, wherein the target source of the multi-arc sputtering equipment is an aluminum target source.

6. The method of claim 1, wherein a N50 grade permanent magnet is placed at the back of the target to control arc rotation within the multi-arc sputtering equipment and adjust a distance between the N50 permanent magnet and the aluminum target to be 1 cm to 10cm.

7. The method of claim 1, wherein the argon gas used in step c) has a purity of more than 99.7%.

8. The method of claim 1, wherein the aluminum coating has a thickness of 0.5 to 15µm.

9. The method of claim 1, wherein step g) of heating the epoxy resin coating is performed at 170°C for 30min.

## Patentansprüche

1. Verfahren zum Aufbringen einer Antikorrosionsbeschichtung auf Nd-Fe-B-Permanentmagneten, wobei das Verfahren die folgenden Schritte umfasst:
a) Durchführung einer Vorbehandlung der Nd-Fe-B-Permanentmagnete;
b) Befestigen der Nd-Fe-B-Permanentmagnete an einer Spannvorrichtung und Platzieren derselben in einer Mehrfachlichtbogen-Sputtereinrichtung;
c) Evakuieren der Mehrfachlichtbogen-Sputtereinrichtung mit einem Vakuumsystem, bis der Druck 1 × 10⁻² Pa bis 3 × 10⁻² Pa erreicht, anschließend Einleiten von Argongas, bis der Druck 1 × 10⁻¹ Pa bis 5 × 10⁻¹ Pa, Beginn der Vorspannungsbehandlung der Nd-Fe-B-Permanentmagneten für 1 bis 10 Minuten bei 800 V bis 1.000 V;
d) Stoppen der Vorspannungsbehandlung und dann Evakuieren der Mehrfachlichtbogen-Sputtereinrichtung, bis der Druck 1 × 10⁻³ Pa bis 8 × 10⁻³ Pa erreicht, anschließend Wiederauffüllen von Argongas, bis der Druck 3 × 10 ⁻¹ Pa bis 5 × erreicht 10 ⁻¹ Pa, dann Starten der Lichtbogenabscheidung von einer Zielquelle und Aufrechterhalten eines Gleichstroms zwischen 50 A bis 70 A, Einschalten der Vorspannung und Aufrechterhalten der Spannung zwischen 100 V bis 200 V und Halten der Beschichtung der Magneten für 0,1 bis 2 Stunden;
e) Abkühlen auf 20 ° C bis 100 ° C und Herausnehmen der Nd-Fe-B-Permanentmagneten aus der Mehrfachlichtbogen-Sputtereinrichtung;
f) Sprühbeschichtung der Nd-Fe-B-Permanentmagnete mit einem Epoxidharz; und
g) Platzieren der Nd-Fe-B-Permanentmagnete in einen Ofen und Wärmebehandeln derselben bei einer Behandlungstemperatur zwischen 100 °C und 220 °C für 10 Minuten bis 120 Minuten.

2. Verfahren nach Anspruch 1, wobei die Nd-Fe-B-Permanentmagnete gesinterte Nd-Fe-B-Permanentmagnete oder schwere Nd-Fe-B-Permanentmagnete mit Seltenerdelement-Diffusionsbeschichtung sind.

3. Verfahren nach Anspruch 1, wobei der Schritt a) der Vorbehandlung der Nd-Fe-B-Permanentmagnete das Entfetten der Oberflächen der Magnete mit einer Entfettungsflüssigkeit und das anschließende Waschen der Oberflächen mit Salpetersäure mit einer Konzentration von 3 % bis 5 %, das Waschen der Oberflächen mit deionisiertem Wasser und schließlich Trockenblasen der Magnete umfasst.

4. Verfahren nach Anspruch 1, wobei in Schritt b) Wasser mit einer Temperatur von 0 °C bis 5 °C zum Kühlen des Mehrfachlichtbogen-Ziels verwendet wird.

5. Verfahren nach Anspruch 1, wobei die Zielquelle der Mehrfachlichtbogen-Sputtereinrichtung eine Aluminium-Zielquelle ist.

6. Verfahren nach Anspruch 1, wobei ein Permanentmagnet der Güte N50 an der Rückseite des Ziels angeordnet ist, um die Lichtbogenrotation innerhalb der Mehrfachlichtbogen-Sputtereinrichtung zu steuern und einen Abstand zwischen dem N50-Permanentmagneten und dem Aluminiumziel von 1 cm bis 10 cm einzustellen.

7. Verfahren nach Anspruch 1, wobei das in Schritt c) verwendete Argongas eine Reinheit von mehr als 99,7% aufweist.

8. Verfahren nach Anspruch 1, wobei die Aluminiumbeschichtung eine Dicke von 0,5 bis 15 µm aufweist.

9. Verfahren nach Anspruch 1, wobei der Schritt g) des Erwärmens der Epoxidharzbeschichtung bei 170 °C für 30 Minuten durchgeführt wird.

## Revendications

1. Procédé d'élimination d'un revêtement de protection contre la corrosion sur des aimants permanents à base de Nd-Fe-B, le procédé comprenant les étapes consistant à :
a) Effectuer un prétraitement des éléments permanents à base de Nd-Fe-B ;
b) Fixer les aimants permanents à base de Nd-Fe-B sur un gabarit et les placer dans un équipement de pulvérisation à arcs multiples ;
c) Évacuer l'équipement de pulvérisation arcs multiples avec un système sous vide jusqu'à ce que la pression atteigne une pression comprise entre 1 x 10⁻² Pa et 3 x 10⁻² Pa, ensuite introduire de l'argon gazeux jusqu'à ce que la pression atteigne une pression comprise entre 1x10⁻¹ Pa et 5x10⁻¹ Pa, commencer un traitement par tension de polarisation des aimants permanents à base de Nd-Fe-B pendant 1 à 10 minutes entre 800 V et 1000 V ;
d) Arrêter le traitement par tension de polarisation et ensuite évacuer l'équipement de pulvérisation à arcs multiples jusqu'à ce que la pression atteigne une pression comprise entre 1 x 10⁻³ Pa et 8 x 10⁻³ Pa, ensuite remplir l'argon gazeux jusqu'à ce que la pression atteigne une pression comprise entre 3 x 10⁻¹ Pa et 5 x 10⁻¹ Pa, ensuite commencer un dépôt à arcs à partir d'une source cible et maintenir un courant continu compris entre 50 A et 70 A, allumer la tension de polarisation et maintenir une tension comprise entre 100 V et 200 V, et maintenir le revêtement des aimants de 0,5 à 2 h ;
e) Refroidir entre 20° C 100° C et retirer les éléments permanents à base de Nd-Fe-B de l'équipement de pulvérisation à arcs multiples ;
f) Revêtir par pulvérisation des aimants permanents à base de Nd-Fe-B avec une résine d'époxy ; et
g) Placer les aimants permanents à base de Nd-Fe-B dans un four et les traiter par chauffage à une température de traitement comprise entre 100 °C et 220 °C pendant 10 min à 120 min.

2. Procédé selon la revendication 1, dans lequel les aimants permanents à base de Nd-Fe-B sont des aimants permanents à base de Nd-Fe-B frittés ou des aimants permanents à base de Nd-Fe-B à diffusion d'éléments de terres rares lourdes.

3. Procédé selon la revendication 1, dans lequel l'étape a) de prétraitement des aimants permanents à base de Nd-Fe-B consiste à dégraisser les surfaces des aimants à l'aide d'un fluide de dégraissage, ensuite laver les surfaces avec de l'acide nitrique possédant une concentration comprise entre 3 % et 5 %, laver les surfaces avec de l'eau désionisée, et finalement sécher les aimants par soufflage.

4. Procédé selon la revendication 1, dans lequel dans l'étape b) de l'eau possédant une température comprise entre 0 °C et 5 °C est utilisée pour refroidir la cible à plusieurs arcs.

5. Procédé selon la revendication 1, dans lequel la source cible de l'équipement de pulvérisation à arcs multiples consiste en une source cible en aluminium.

6. Procédé selon la revendication 1, dans lequel un aimant permanent de type N50 placer à l'arrière de la cible pour commander la rotation à arc au sein de l'équipement par pulvérisation à arcs multiples et pour ajuster une distance entre l'élément permanent N50 et la cible en aluminium qui soit comprise entre 1 cm et 10 cm.

7. Procédé selon la revendication 1, dans lequel l'argon gazeux utilisé dans l'étape c) possède une pureté supérieure à 99,7 %.

8. Procédé selon la revendication 1, dans lequel le revêtement en aluminium possède une épaisseur comprise entre 0,5 et 15 µm.

9. Procédé selon la revendication 1, dans lequel l'étape g) de chauffage du revêtement à base de résine époxy est effectuée à 170 °C pendant 30 min.
